# EUROPEAN PATENT APPLICATION

(11) **EP 1 477 762 A2**
(43) Date of publication of application: **17.11.2004**
(21) Application number: 04076228.8
(22) Date of filing: 26.04.2004
(51) Int. Cl.: F28D 15/04, H01L 23/427

(54) **Thermosyphon and method for producing it**

(30) Priority: 12.05.2003 SE 0301381
(71) Applicant: Sapa AB, 114 85 Stockholm (SE)
(72) Inventor: Hou, Jin, 602 09 Norrköping (SE); Bengtsson, Bo, 612 34 Finspong (SE); Tuovinen, Seppo, 612 37 Finspong (SE); Norlin, Anders, 612 37 Finspong (SE)

(57) **Abstract**

The present invention relates to thermosyphons, in particular for use in the cooling of electronic components. In a first embodiment a thermosyphon is manufactured by extruding a base (1) and milling a channel structure in the base to produce a plurality of fins (5) extending vertically from the base. A lid (3) comprising a number of fins (4) extending vertically from the lid is placed over the heat sink channel structure so that a thermosyphon of an expanding channel system is formed. In a second embodiment the evaporator and condenser sections are separated and connected by pipes. To form a leak proof seal between the lid and the base, joining is preferably done by friction stir welding. By providing an extruded thermosyphon, heat transfer is made more efficient than when junctions are used. The present invention provides a new way of efficiently manufacturing an integrated structure, while keeping the heat transfer of the structure high.

## Description

### Technical field

The present invention relates to thermosyphons, in particular for use in the cooling of electronic components.

Thermal management is a key issue in the design of the electronic package. The proper design insures that the peak temperatures remain within a specified operating range to produce a reliable module. The main objective is to maintain the semiconductor device junction temperature below the maximum operating temperature of the module. Design challenges included in heat removal are higher circuit densities, close proximity of adjacent devices or components, low thermal conductivity substrates, inner layers of metal forming the interconnect, and the thermal resistance of heat sink systems.

The purpose of any heat transfer design is to allow the flow of thermal energy from heat source to heat sink within the constraints of specified temperature levels. The current trend towards miniaturisation of electronic devices, greater functionality and faster processor results in a steady increase in heat dissipated per unit area. Multi-chip modules having an increasingly close placement of components having high heat fluxes means that the various thermal resistances, from the internal heat sources to the external final heat sink, must be reduced. This puts new demands on cooling and heat spreading technology.

As air cooling is approaching it's limits a lot of researchers have re-focused upon liquid cooling techniques with phase-change in a closed channel. Two known types of devices in particular employ this phase-change mechanism for heat transfer from electronic circuit components: thermosyphons and heat pipes. These components take advantage of the heat of vaporisation of the fluid by transporting heat from an evaporator to a condenser through the liquid-vapour phase change.

A thermosyphon has an evaporator section, an adiabatic section, and a condenser section. In operation, electronic devices produce heat which is absorbed in the evaporator section of the thermosyphon which causes evaporation into vapour of a working fluid that is in the evaporator section. Working fluid in the form of vapour moves through the adiabatic section to the condenser section where it gives up its latent heat and condenses into liquid. The condensed liquid returns to the evaporator section from the condenser section with the aid of gravity. Therefor, in a thermosyphon the evaporator should always be placed lower than condenser.

### Background of the invention

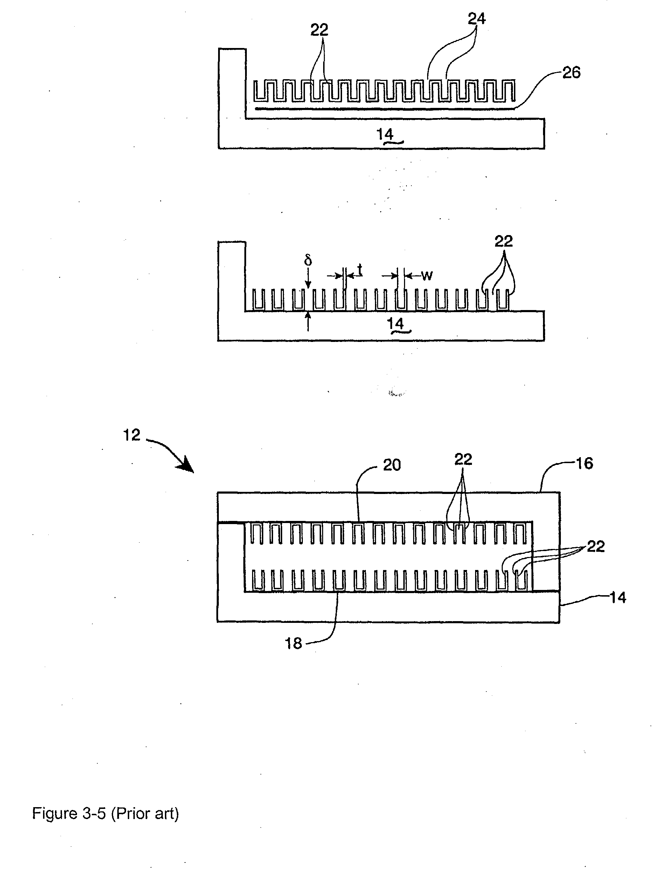

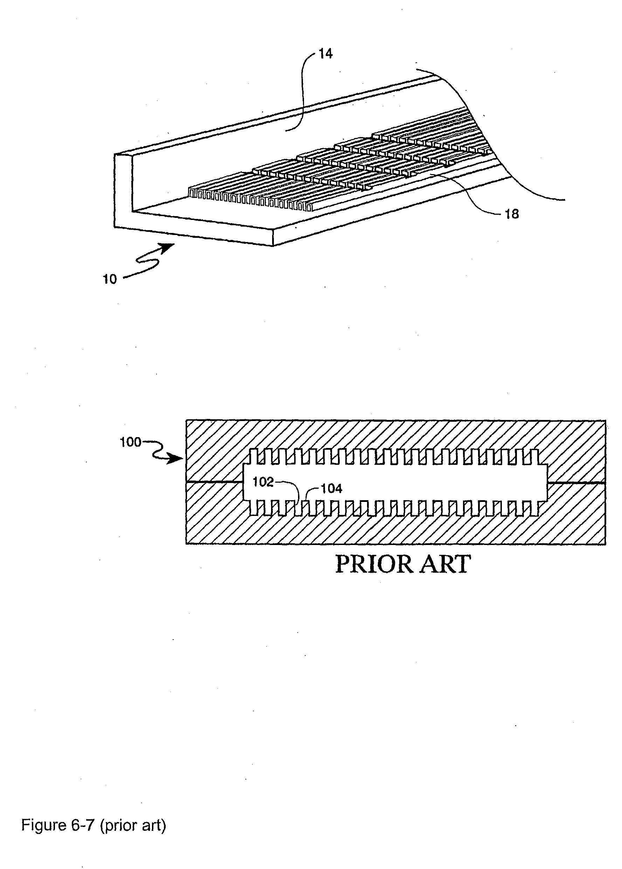

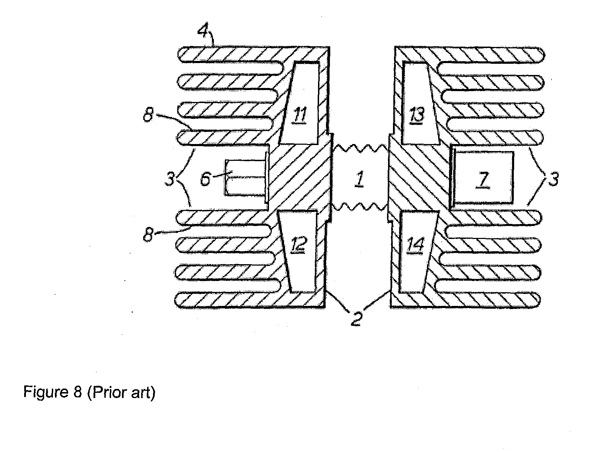

Heat pipes are known from US-6216343. FIG. 3-6 of this prior art patent shows different embodiments of micro channel heat pipe. In figure 6 a corrugated fin element 18 wherein material is removed is used. In this way fabrication is simplified by reducing machining time. Other configurations are possible, such as removal of material across the entire longitudinal axis, creating only open micro capillary channels, such as those marked 22 in figure 5. FIG. 7 shows a micro channel heat pipe 100 made according to the prior art groove machining techniques. The open capillary channels 102 are separated by solid ridges 104 of housing material. The micro channel heat pipes of the prior art is fabricated by difficult and time consuming manufacturing techniques.

US-6418017 describes an integrated heat pipe/heat sink manufactured by mechanically scribing grooves length-wise in a channel drilled into a chassis for electronic components. The chassis is cast or moulded and may comprise fins to more effectively dissipate heat. The use of extrusion as a manufacturing method is not mentioned.

From GB-2151769 it is known to manufacture extruded heat sinks having internal cavities acting as thermosyphons (see figure 8). The cavities are elongated without any internal structure. The cooling efficiency of this kind of thermosyphon is limited.

In "Thermosyphon concept for cooling of PCB", Rahmatollah, K et al, 8^{th} THERMINIC Workshop, 1-4 October 2002, Madrid, a concept of cooling PCB:s by using an aluminium sheet having a milled channel system. The thermosyphon is attached to the heat sink, and thus not integrated with it as in the present invention.

Bearing in mind the problems and deficiencies of the prior art, it is an object of the present invention to provide a method suitable for mass production of the thermosyphon of the present invention.

It is another object of the present invention to provide a thermosyphon with a more efficient heat transfer than could be obtained by the thermosyphons of the prior art.

### Detailed description

Figure 1 a-c shows an embodiment of the thermosyphon according to the invention.
Figure 2a shows the thermosyphon according to a preferred embodiment of the present invention.
Figure 2b shows an alternative solution according to the present invention.
Figure 3-8 shows heat sink constructions according to the prior art.

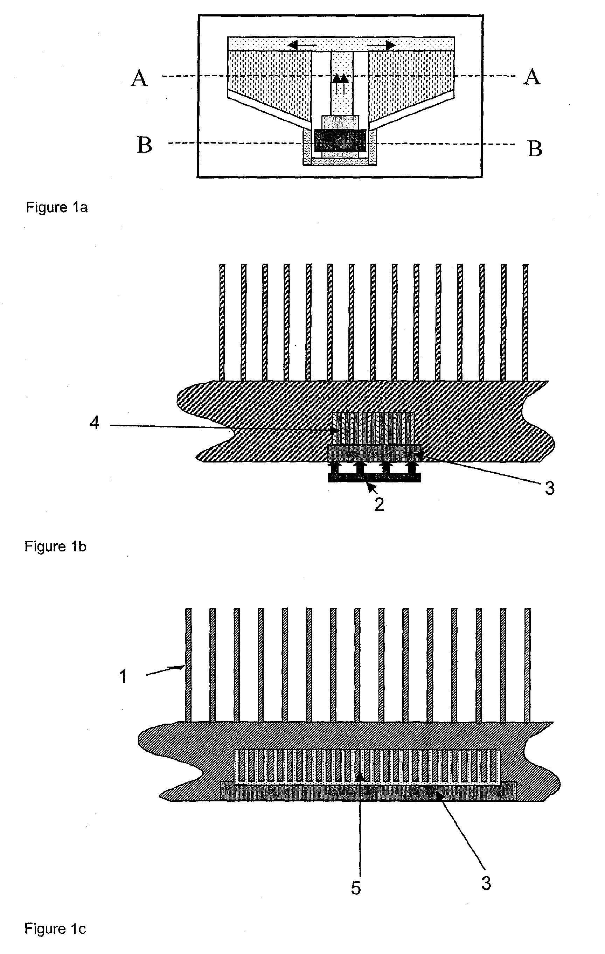

In figure 1a the principle of the integrated thermosyphon according to a first embodiment is shown. A working fluid is heated in the evaporator section whereby the working fluid evaporates and the vapour formed travels in the direction of the arrows, and is condensed back to liquid in the condenser section. Figure 1b is a cross section taken across the line B-B. Here the evaporator fins (4) are integrally produced with the lid (3) by extruding the lid and cutting the extruded profile in desired lengths, whereafter the fins in areas outside the evaporator section are removed by milling. The condenser section shown in figure 1c, as a cross section taken across the line A-A in figure 1a. The thermosyphon further comprises extruded heat dissipating fins (1) extending from the base. Other solutions resulting in the same or similar s may be obtained by extruding part of the condenser as a part of the lid, or manufacturing the evaporator section as a part of the heat sink base.

The fins of the evaporator and/or condenser section, at least partially produced by extrusion, form an internal structure with an extended surface area, providing a more efficient heat transfer between the working fluid and the thermosyphon.

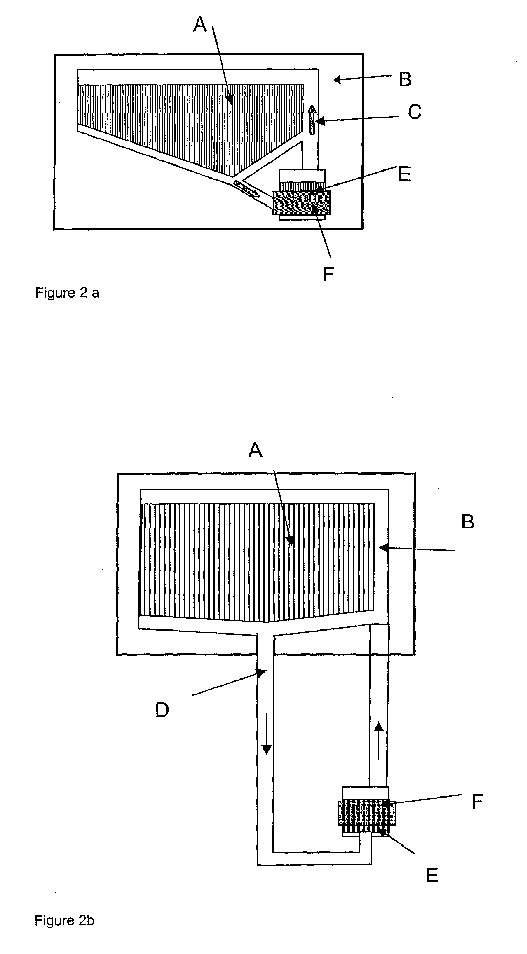

Referring to figure 2a a thermosyphon according to the invention is shown having a base (B) and a plurality of condenser fins (A) extending vertically from the base. A lid comprising a number of evaporator fins (E) with a separating distance smaller than the distance between the condenser fins extending vertically from the lid is placed over the channel structure (D) so that a thermosyphon of an expanding channel system is formed. A heat dissipating component (F) is attached to the outside of the lid.

By integrating the lid and the evaporator fins into one part, the contact thermal resistance between the lid and the fins is eliminated, which makes the thermosyphon more efficient. The heat dissipating fins are integrated in the thermosyphon, which eliminates the contact thermal resistance between the condenser fins and the outer heat dissipating fins.

Figure 2b shows an alternative embodiment, the reference letters referring to the same components as in figure 2a, where the condenser section and the evaporator section are separated and connected by pipes (D) conducting the evaporated working media from the evaporator to the condenser where it is condensed to a liquid and transferred by gravity back to the evaporator. Lids are placed over the evaporator and condenser sections in a similar way as in the first embodiment.

To form a leak proof seal between the lid and the heat sink, joining is preferably done by, but not limited to, friction stir welding. This joining technique is described in EP-A-615480. Typically, a friction welding tool (a probe), inserted into a joint region to be welded, undergoes a cyclic motion to generate a plastizised material and is typically traversed along the joint region. When the material cools a joint of high quality is produced.

By providing an integrated heat sink/thermosyphon, heat transfer is made more efficient than when junctions are used. The present invention provides a new way of efficiently manufacturing an integrated structure, while keeping the heat transfer of the structure high.

The material selection for the base and lid depends on application requirements for ease of fabrication and service reliability. Aluminum is preferred because of its ease of machinability and lower density compared to other metals, but other materials may also be used.

### Example

A lid is extruded from an aluminium billet so that a plate is formed having fins extending from one side along the centre of the plate. The fins extending beyond the area dedicated to the evaporator are removed by milling to form the evaporator section, E, according to figure 2a. A base is then extruded to form a plate having heat dissipating fins extending from one side. The flat side of the base is machined so that condenser channels, A, are formed in a pattern according to figure 2a as well as a cavity for the evaporator fins to fit into. The lid is joined to the base by traversing a friction stir welding tool along the joint (shown as the contour of the thermosyphon in figure 1a). When the lid and the base are joined a sealed chamber constituting a thermosyphon is formed inside the chamber. The evaporator is filled with liquid. The choice of working fluid is based upon the working temperature of the thermosyphon, and may be chosen according to the specific demands in each case. The heat source (F) is attached to the lid. Under thermal loading, a part of the liquid in the evaporator transforms to gas and flows up to condenser where the vapour is condensed to liquid and flows back to evaporator via the liquid return channel.

While the present invention has been particularly described in conjunction with a specific preferred embodiment, it is evident that many alternatives, modifications and variations will be apparent to those skilled in the art in light of the foregoing description. The evaporator may for example be a part of the base and the condenser a part of the lid. All parts may be extruded including the fins of the condenser and the fins removed from areas used for joining of the parts. In the latter case all of the fins may be produced integrally with either the lid or the heat sink base or as parts of either the lid or the base.

By extruding parts or all of the parts of the thermosyphon manufacturing is simplified and heat transfer improved.

## Claims

1. A thermosyphon comprising a base (1), a condenser section (5) and an evaporator section (4) conducting heat from a heat source (2) by the use of a working fluid, ***characterized in that*** the evaporator and/or the condenser section has an internal structure providing an extended surface area, where at least a part of the internal structure has been produced by extrusion.

2. A thermosyphon according to claim 1 or 2, where the condenser and the evaporator sections are integrated into a confined chamber, the chamber being sealed by a lid (3).

3. A thermosyphon according to any of claim 2, where the extruded part of the thermosyphon is an integrated part of the lid.

4. A thermosyphon according to any of claims 1-3, where the condenser and the evaporator sections are separate structures joined by pipes transporting the working fluid.

5. A thermosyphon according to claim 4, where the lid is extruded and comprises at least a part of the internal structure.

6. A thermosyphon according to any of claims 2-5, where the lid is attached by friction stir welding.

7. A thermosyphon according to any of claims 1-6, where at least a part of the thermosyphon is made of aluminium or an aluminium alloy.

8. A thermosyphon according to any of claims 1-7, where the structure comprises heat dissipating fins extending from the base towards the outside of the thermosyphon.

9. A method of producing a thermosyphon structure according to any of claims 1-8, where at least a part of the internal structure is produced by extrusion.

10. A method of producing a thermosyphon according to claim 9, where the lid is attached to the base by friction stir welding.

11. Use of a thermosyphon according to claims 1-8 for the cooling of electronic components.
